# EUROPEAN PATENT SPECIFICATION

(11) **EP 0 499 433 B1**
(45) Date of publication and mention of the grant of the patent: **15.04.1998**
(21) Application number: 92301098.7
(22) Date of filing: 10.02.1992
(51) Int. Cl.: H01L 21/768, H01L 23/485

(54) **Semiconductor device with improved reliability wiring and method of its fabrication**
Halbleiter-Vorrichtung mit Verdrahtung der verbesserten Zuverlässigkeit und Verfahren zu ihner Herstellung
Dispositif semi-conducteur ayant un cablage à fonctionnement amélioré, et procédé pour sa fabrication

(30) Priority: 12.02.1991 JP 18642/91
(43) Date of publication of application: 19.08.1992
(73) Proprietor: MATSUSHITA ELECTRONICS CORPORATION, Kadoma-shi, Osaka 571 (JP)
(72) Inventor: Kanazawa, Masato, Kyoto-shi, Kyoto 612, Japan (JP)
(74) Representative: Crawford, Andrew Birkby

(56) References cited:
- EP-A- 0 388 563
- EP-A- 0 430 403
- US-A- 4 107 726
- US-A- 4 357 203
- PATENT ABSTRACTS OF JAPAN vol. 013, no. 574 (E-863)19 December 1989 & JP-A-1 241 149 ( SEIKO EPSON CORP. )
- PATENT ABSTRACTS OF JAPAN vol. 014, no. 550 (E-1009)6 December 1990 & JP-A-2 235 372 ( MITSUBISHI ELECTRIC CORP ) 18 September 1990
- PATENT ABSTRACTS OF JAPAN vol. 014, no. 032 (E-876)22 January 1990 & JP-A-1 266 746 ( SONY CORP )
- THIN SOLID FILMS vol. 164, October 1988, LAUSANNE CH pages 417 - 428 N. KUMAR ET AL
- JOURNAL OF APPLIED PHYSICS. vol. 68, no. 3, 1 August 1990, NEW YORK US pages 1043 - 1049 A. S. BHANSALI ET AL

## Description

The present invention relates to the reliability of connection holes between wiring layers formed within a semiconductor device, and more particularly to a semiconductor device having a much higher connection hole reliability than devices with the conventional connection hole structure, and a method of fabricating such devices.

Recently, as the degree of integration of semiconductor devices has advanced, wiring layers within such devices have tended to become very fine and it has become known to use a plurality of wiring layers.

At present, even the semiconductor memory devices at the forefront of progress towards finer technology use multilayer wiring technology.

Multilayer wiring technology employs a polycide film with two layers of polycrystalline silicon and refractory metal silicide. This is because it is difficult to obtain multilayer wiring with both multiple layers and finer layers using aluminium alloy film which is used to form single wiring layers.

However, the sheet resistance of a wiring layer using polycide film is approximately two orders of magnitude higher than that of a wiring layer of aluminium alloy film. Therefore, when manufacturing a semiconductor device operating at high speed, a wiring delay due to the use of polycide film occurs. When compared with devices using aluminium alloy film, such semiconductor devices do not operate at a high speed. It would therefore be advantageous to make a device with multiple layers using an aluminium alloy film with low sheet resistance, thereby maintaining the reliability of the semiconductor device.

With the progress of finer technology, there is also a trend towards finer layers in the field of microcomputers e.g. logic, ASIC, and grate arrays. In particular, the operating speed and functions of microprocessing units (MPUs) are being upgraded progressively, and, therefore, a much finer technology is expected to be developed. The performance of the MPU varies with the size of the data to be handled. For example, in the same 32-bit MPUs, the performance is determined by the complexity of the function provided and its operating frequency, that is, the magnitude of the processing speed.

At present, the operating frequency is about 50 MHz in a 32-bit MPU. With the current degree of integration 1,000,000 transistors are formed in an area no larger than. However further degrees of integration are necessary in order to raise the operating frequency and achieve higher functions in MPUs. Thus a sophisticated finer technology is needed.

In order for MPUs to operate at high speed as well as performing complex functions, lowering of operating speed due to wiring delay should be avoided. To achieve this multilayer wiring using aluminium alloy film has been used. To improve the performance of the MPU, therefore, it is important to make multilayer wiring technology finer while using aluminium alloy film.

Problems which occur in making fine wiring using aluminium alloy film are deterioration and breakdown of the wiring by migration. Such reliability problems of semiconductor devices are major factors as they impede the progress toward finer technology.

Migration is classified into electromigration and stress migration. Much is known of the deterioration phenomenon of wiring by stress migration. For example, it is discussed in the 25th Annual Proceedings Reliability Physics 1987, pp. 15-21 in an article entitled "The Effect Of of Cu Addition to Al-Si Interconnects on Stress Induced Open-Circuit Failure". Stress migration occurs when wiring using aluminium alloy film is subjected to stress between the interlayer dielectric film surrounding the wiring and the passivation film, and changes in temperature with time in use. Because of such stress and changes in temperature, the aluminium atoms in the aluminium alloy film move leaving cavities or voids in the wiring. As such voids build up, the wiring is finally broken down. This phenomenon is called stress migration. The above mentioned article proposes adding copper to the aluminium alloy film. This results in copper precipitating into the crystal grain boundaries in the aluminium film, and thereby suppressing movement of aluminium atoms. The articles states that the resistance to stress migration is thereby improved. This article is therefore concentrated with wiring using aluminium alloy film.

Another consideration is that, for finer multilayer wiring technology using aluminium alloy film, as the width of the wiring is reduced, it is also necessary to reduce the size of connection holes between upper and lower wirings. The diameter of such connection holes must be smaller than the minimum width of the upper and lower wirings. For example, if the width of the wiring is 1.0 um, the diameter of connection hole must be not greater than 1.0 um. If connection holes are used with a diameter greater than the minimum possible width of the wiring, the width of the wiring must be made not smaller than the size of the connection hole. Therefore, the density of the wiring cannot be increased easily, and the degree of integration cannot be improved. Hence, the chip size is larger than it might otherwise be for a semiconductor device with a particular function.

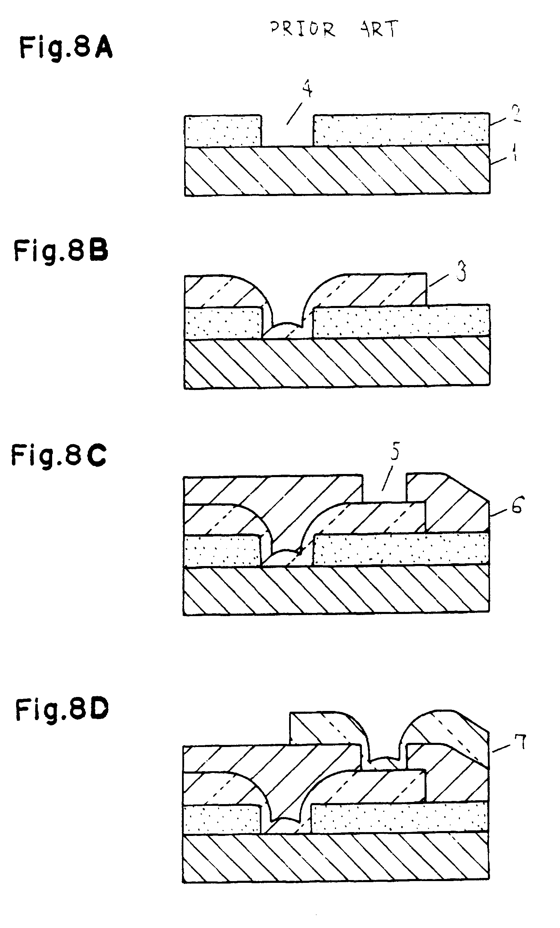

A prior art device is described below with reference to Fig. 8 which is a process sectional view showing the manufacturing method of such a device. As an example a semiconductor substrate of a first conductive type (P-type) is described. It is assumed in the following explanation that a semiconductor element, such as an ordinary MOS transistor, a MOS capacitor, a bipolar transistor or a resistor (not shown) is formed in the P-type substrate 1.

On the P-type semiconductor substrate 1, a silicon oxide film is formed as a first interlayer dielectric film layer 2. The silicon oxide film is for example, an SiO₂ a film, a BPSG (Boron-Phospho-Silicate Glass) film, or a PGS (Phospho-Slicate Glass) film formed using low pressure chemical vapour deposition or atmospheric pressure chemical vapour deposition.

Next, a specified portion of the first interlayer dielectric film layer 2 is selectively removed to form a first connection hole 4. The P-type semiconductor substrate 1 is thus exposed in the bottom of the first connection hole 4. The native oxide film which forms on the exposed semiconductor substrate 1 is removed, and a first conductive film layer 3 is formed in a specified area which includes the first connection hole 4 (Fig. 8A). This first conductive film layer 3 is formed into a desired pattern by anisotropic etching such as Reactive Ion Etching (hereinafter called RIE), and the device is heat treated at a temperature of about 450°C (Fig. 8B).

A second interlayer dielectric film layer 6 is then formed on the first conductive film layer 3 and a specified portion of the second interlayer insulation film layer 6 is selectively removed to form a second connection hole 5. The native oxide film which forms on the first conductive film layer 3 exposed in the bottom of the second connection hole 5 is removed to expose the surface of the first conductive film layer 3. A second conductive film layer 7 is formed in a specified area which at least includes the second connection hole 5 (Fig. 8C). The second conductive film layer 7 is formed of aluminium alloy film and is formed into a desired pattern by anisotropic etching such as RIE (Fig. 8D).

Thus a two-layer wiring structure is fabricated.

A passivation film is then formed on the semiconductor element having a film thickness of 500 to 1200 nm.

In a semiconductor device fabricated by the above described known method, degradation due to storage at high temperature (eg. 180°C) occurs. A semiconductor device used for measuring the degree of deterioration is fabricated as described below. As a first interlayer dielectric film layer 2, a BPSG film is deposited on the P-type semiconductor substrate having a film thickness of 60nm. A first conductive film layer 3 is deposited on the BPSG film. A second interlayer dielectric film layer 6 is formed thereon. A second connection hole 5 is formed in the second interlayer dielectric film layer 6. A second conductive film layer of aluminium alloy film is deposited having a film thickness of 1000 nm followed by a passivation film of a PSG film 300 nm thick and a silicon nitride film 800 nm thick.

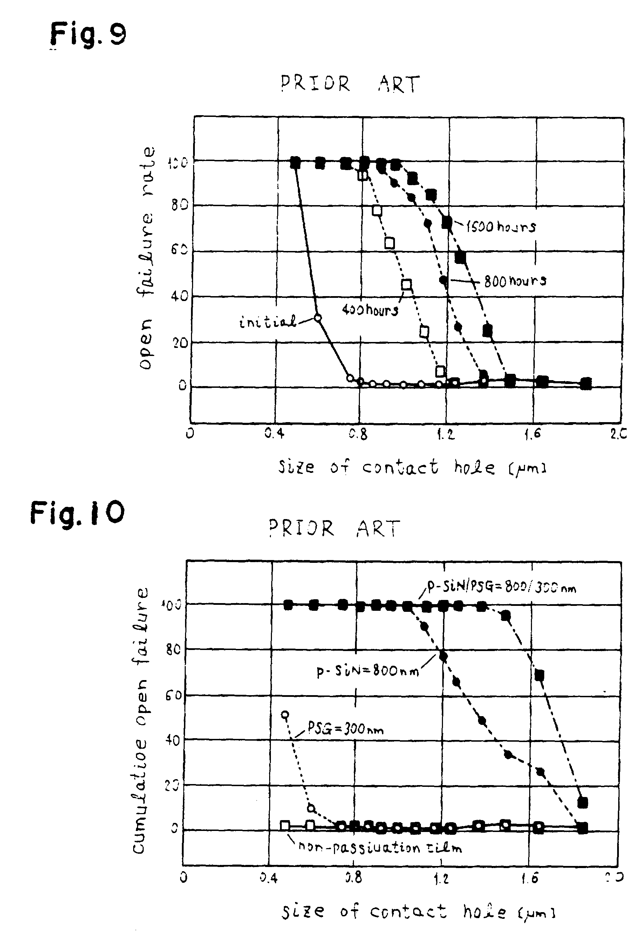

Fig. 9 shows the relationship between the contact hole size and the open failure rate of the second connection hole after various lengths of storage at 180°C.

As the high temperature storage time is increased, the open failure rate increases. When the diameter of second connection hole 5 is smaller than about 1.4 um, the open failure rate increases sharply for a storage time of 1600 hours. That is, in the prior art devices, although the conductive state is properly established during manufacture, failure of the connections in the semiconductor device occurs as a result of high temperatures. When the diameter of the connection hole is smaller than a particular size, open failure is caused, and this poses a serious reliability problem.

Thus, in the prior art semiconductor devices with multilayer wiring, when the diameter of the second connection holes 5 becomes small, it causes serious reliability problems.

When multilayer wiring is made having a fine structure in prior art semiconductor devices in addition to the wiring breaking due to the stress migration, open failure of the connection holes occurs, and a serious reliability problem occurs when the diameter of the connection holes is smaller than about 1.4 um.

A failed semiconductor device was analysed by a focused ion beam (FIB) technique and it was found that voids are formed in the aluminium alloy film (the second conductive film layer 7), at the interface between the first conductive film layer 3 and the second conductive film layer 7 in the second connection hole 5. Such voids cause the breakdown of the aluminium alloy film (the second conductive film layer 7). This, therefore is the mechanism of disconnection which causes the open failure decried above.

The same problem occurs when copper elements are initially added to the aluminium alloy film.

The correlation of open failure rate and stress in the passivation film was also considered as a possible cause of open failure. The stress in the passivation film varies according to the type of passivation film. As a result of measuring first semiconductor devices having a passivation film formed of two layers, i.e. a PSG film 300 nm thick and a silicon nitride film 800 nm thick, second semiconductor devices having a passivation film formed of a single layer, i.e. a PSG film 300 nm thick, third semiconductor devices having a passivation film formed of a single layer, i.e. a silicon nitride film 800 nm thick, and fourth semiconductor devices without a passivation film, it is established that a PSG film formed by an atmospheric pressure chemical vapour deposition method has a tensile stress of 2 x 10⁻¹⁰N/m², and the silicon nitride film formed by a plasma enhanced chemical vapour deposition method has a compressive stress of 9 x 10⁻¹⁰N/m².

Fig. 10 shows the cumulative open failure of each type of semiconductor device mentioned above after high temperature storage at 180°C in a nitrogen atmosphere for 1000 hours.

In semiconductor devices without a passivation film the cumulative open failure does not increase as the contact hole is made smaller, while in semiconductor devices formed with a silicon nitride film having a strong compressive stress the cumulative open failure is clearly increased.

In the prior art, the second conductive film layer 7 was formed by sputtering. As a result, in the second connection hole, the coverage of the second conductive film layer 7 is poor. Hence the second conductive film layer 7 in the second connection hole 5 is very thin. Therefore, because of the stress in the passivation film above, the aluminium atoms are moved, and voids are formed in the second connection hole 5, thereby easily leading to open failure.

It is known to improve the coverage of the second conductive film layer 7 by burying the second connection hole 5 with the conductive film layer. For example, by burying the hole with tungsten, the coverage of the second conductive film layer 7 in the second connection hole 5 may be markedly improved. However, there is a disadvantage in burying with tungsten in that the resistance of tungsten is approximately one order of magnitude higher than that of conventional aluminium alloy film. Because of this increase in the resistance a wiring delay is caused which may lead to operating errors in the semiconductor device. It is the therefore necessary to plan the design again taking the resistance increase into consideration, and the conventional designs cannot be used directly.

In summary, the problem discussed above, i.e. the occurrence of voids in the second connection hole 5, may simply be avoided by forming the second conductive film layer 7 of a refractory metal such as tungsten. Since the melting point of tungsten and other refractory metals is high the wire is not easily broken by stress in the passivation film. However, tungsten and other refractory metals have a higher resistivity than aluminium alloy film, and the wiring resistance increases.

It is known. for instance from US-A-4107726, to form the second conductive film of two layers, the first being a refractory metal layer, for instance of titanium, and the second being a metal layer, for instance aluminium. In the above mentioned document the refractorv metal layer is formed to be 180nm.

The present invention provides a semiconductor device comprising:
a semiconductor substrate;
a first interlayer dielectric film layer formed on the semiconductor substrate and having at least one first connection hole at a specified position therein;
a first conductive film layer formed on the first interlayer dielectric film layer and over a specified area including said at least one first connection hole;
a second interlayer dielectric film layer formed on the first conductive film layer and having at least one second connection hole at a specified position therein; and
a second conductive film layer comprising a refractory metal film and an aluminium alloy film formed on the second interlayer dielectric film layer over a specified area including said at least one second connection hole;
characterized in that the thickness of the refractory metal film is in the range 30-100nm, and in that the refractory metal film is alloyed with the aluminium alloy film and the first conductive film layer in the at least one second connection hole.

The present invention also provides a method of fabricating a semiconductor device comprising:
forming a first interlayer dielectric film layer on a semiconductor substrate,
forming at least one first connection hole in the first interlayer dielectric film layer to expose the semiconductor substrate,
removing oxide film from the exposed surface of the semiconductor substrate,
forming a first conductive film layer on the first interlayer dielectric film layer and over a region including at least the exposed semiconductor substrate surface,
forming a second interlayer dielectric film layer on the first conductive film layer,
forming at least one second connection hole in the second interlayer dielectric film layer to expose the first conductive film layer;
removing oxide film from the first conductive film layer;
forming a second conductive film layer on said second interlayer dielectric film layer comprising a lower layer of a refractory metal film and an upper layer of an aluminium alloy film over a region including at least the at least one second connection hole;
characterized in that the refractory metal film (27A) is formed to have a thickness in the range 30-100nm, in that the layer of a refractory metal film and the layer of aluminium alloy film are formed sequentially in a continuous process without exposure to air, and by further comprising heating in a reducing atmosphere after the formation of the second conductive film layer whereby the refractory metal film layer is alloyed with the aluminium alloy film and the first conductive film layer in the at least one second connection hole.

An advantage of the preferred embodiment of the invention is that the second conductive film layer is not easily moved by the stress of a passivation film. Another advantage is the suppression of the formation of voids in the second connection hole. Wiring resistance is also kept to a minimum in this invention. In particular a semiconductor device is described which has good reliability even if the diameter of the connection hole in multilayer wiring using aluminium alloy film is smaller than about 1.4 um, together with a method for manufacturing such a device.

In a semiconductor device according to the present invention a refractory metal film is used as a barrier metal film in the first conductive film layer to prevent monocrystalline silicon precipitating in the contact area of the aluminium alloy film and the semiconductor substrate, and contact failure in the contact area due to precipitation of monocrystalline silicon is prevented. Also aluminium spikes are not induced in the first connection hole due to mutual diffusion of the aluminium alloy film and the silicon of the semiconductor substrate.

In a particular embodiment a titanium film is used in the lower layer of the first conductive film layer together with an intermediate layer of titanium nitride. In this arrangement the nitrogen leaving the titanium nitride film of the intermediate layer is prevented from entering the aluminium alloy film, and therefore shortening of life due to electromigration of the aluminium alloy film may be prevented.

Moreover, since the titanium film of the upper layer and aluminium alloy film are preferably alloyed, movement of aluminium atoms in the aluminium alloy film is suppressed. By alloying both of them, in addition, grain growth in the aluminium alloy film may be suppressed, i.e. occurrence of voids formed in the aluminium alloy film may be prevented and the resistance to stress migration may be enhanced.

There is preferably an anti-reflection film on the first conductive film layer, so that a photoresist pattern transferred as a mask pattern may be formed thereon in a specified region.

In one embodiment of this invention the second interlayer dielectric film layer comprises three layers of silicon oxide film the middle one of which is silica. In this arrangement, the lower silicon oxide layer prevents the first conductive film layer from oxidizing due to moisture in the middle silicon oxide film and the upper silicon oxide film prevents moisture absorption by the middle silicon oxide film.

The second interlayer dielectric film layer described above is preferably formed such that the middle silicon oxide film layer flattens the surface step difference caused by the first conductive film layer, so that the second conductive film layer may not be broken.

The semiconductor device of the invention is preferably heat-treated which causes the refractory metal film and the aluminium alloy film layer which form the second conductive film layer to be alloyed, so that movement of aluminium atoms may be suppressed. Besides, since the refractory metal gets into the aluminium alloy film by alloying, grain growth within the aluminium alloy film may be suppressed, and formation of voids in the aluminium alloy film may be prevented. As a result, the resistance of the aluminium alloy film to stress migration may be improved.

In the semiconductor device of the invention, moreover, by forming a refractory metal beneath the second conductive film layer, movement of atoms in the second conductive film layer due to stress in a passivation film formed thereon may be prevented, and the occurrence of voids in the second connection hole may be suppressed. The increase of wiring resistance due to the refractory metal is kept to a minimum, and when the invention is used in prior art design models operating errors in the semiconductor devices are not caused and prior art design techniques may be utilized directly.

Further, in a semiconductor device according to this invention, if the diameter of the second connection hole is greater than about 0.7 um, the open failure rate did not increase due to storage at high temperatures (e.g. 180°C).

Even if the coverage of aluminium alloy film in the second connection hole is poor, the open failure rate can be reduced by utilizing this invention.

The open failure rate may be also reduced by controlling the thickness of the titanium film which preferably forms the refractory metal film and the diameter of the second connection hole.

Increase of the open failure rate may be also prevented in a preferred embodiment by forming a silicon nitride film having a high stress directly on the second conductive film layer as a passivation film.

As mentioned above titanium film is preferably used at the refractory metal. This is very reactive and alloying is easily achieved with the first conductive layer in the bottom of the second connection hole. Thus the likelihood of failure of the contact between the first conductive film layer and the second conductive film layer through the second connection hole is decreased. Thus, the refractory metal film prevents the formation of voids in the aluminium alloy film, and by using titanium film as the refractory metal film, contact failure in the second connection hole may be decreased. Similar effects may also be obtained by using an alloy film of titanium and an other refractory metal, for example, an alloy of titanium and tungsten.

According to the preferred method of fabricating semiconductor devices of the invention, since the second connection hole is formed by a combination of isotropic etching and anisotropic etching, the wiring does not form a sharp step shape in the connection hole.

After removing the native oxide film formed on the first conductive film layer preferably by Argon back sputtering, the second conductive film layer is formed without the device being exposed to the atmosphere, so that the contact of the two is secure and contact failure is avoided.

Besides, in the method of fabricating semiconductor devices of the invention, since the refractory metal film is preferably heat-treated to alloy also the first conductive film layer, the contact between the first conductive film layer and second conductive film layer becomes tighter. As a result, lowering of yield due to contact failure is prevented. At the same time, any damage caused by etching may be recovered by heat treatment.

Prefered embodiments of this invention will be described by way of example with reference to the accompanying drawings, in which
Fig. 1 is a sectional view showing a semiconductor device according to this invention;
Fig. 2 is a process sectional view showing the fabricating method of the semiconductor device of this invention;
Fig. 3 is a diagram showing the relationship between the open failure rate and the size of the connection hole in a device according to this invention;
Fig. 4 is a diagram showing the relationship between the contact resistance value and the size of the connection hole in a device according to this invention;
Fig. 5 is a diagram showing the dependence of the open failure rate on the titanium film thickness in this invention;
Fig. 6 is a diagram showing the relationship between the storage time at 180°C and the open failure rate in this invention;
Fig. 7 is a diagram showing the yield for semiconductor devices fabricated according to this invention as compared with the prior art devices;
Fig. 8 is a process sectional view showing the fabricating method of a semiconductor device in the prior art;
Fig. 9 is a diagram showing the relationship between the size of the connection hole and the open failure rate in the prior art; and
Fig. 10 is a diagram showing the dependence of the cumulative open failure rate on the stress of passivation film in the prior art.

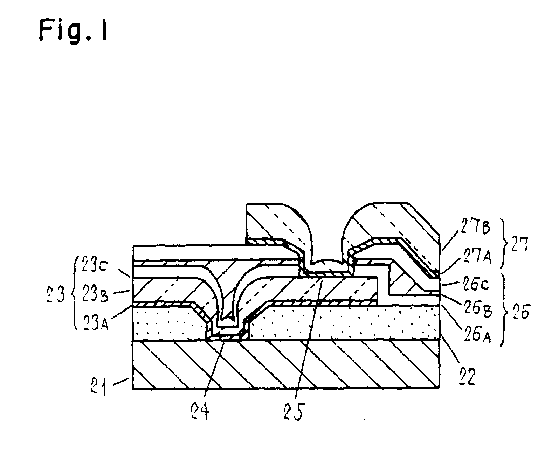

Referring to the drawings, an embodiment of the invention is described in detail below. Fig. 1 is a sectional view useful for explaining a first embodiment of the semiconductor device of the invention.

As an example a semiconductor substrate 21 of a first conductive type (P-type) is described. However, the following description is also applicable to an N-type semiconductor. In the following explanation, it is assumed that any one of the ordinary semiconductor elements such as a MOS transistor, MOS capacitor, bipolar transistor or resistor (not shown) has already been formed on the P-type semiconductor substrate 21.

A first interlayer dielectric film layer 22 is formed on the P-type semiconductor substrate 21. The first interlayer dielectric film layer 22 is made of a BPSG film formed by an atmospheric pressure chemical vapour deposition method.

Instead of the BPSG film, however, other dielectric films may be used such as an SiO₂ film or a PSG film. The first interlayer dielectric film layer 22 is arranged to maintain the dielectric strength between the semiconductor element formed in the P-type semiconductor substrate 21 and a first conductive film layer 23. The thickness of the first interlayer dielectric film layer 22 is about 400 to 1000 nm. The first interlayer dielectric film layer 22 is also arranged to improve the step coverage of the first conductive film layer 23 formed thereon.

A first connection hole 24 is formed at a specified position in the first interlayer dielectric film layer 22. The first connection hole 24 is formed in a shape so as not to break the first conductive film layer 23 above. That is, the shape of the first connection hole 24 is tapered so that the opening at the top of the first interlayer dielectric film layer 22 is larger than the opening at the bottom.

The first conductive film layer 23 is formed over an area which at least covers the first connection hole 24. The first conductive film layer 23 comprises three layers; a barrier metal film 23A, an aluminium alloy film 23B and an anti-reflection film 23C. The first conductive film layer 23 may alternatively comprise a single layer of aluminium alloy film alone, or two layers of barrier metal film and an aluminium alloy film, or two layers of aluminium alloy film and an anti-reflection film.

The first conductive film layer 23 is appropriately alloyed by the P-type semiconductor substrate 21. Accordingly, the contact characteristic is stabilized.

The thickness of the aluminium alloy form 23B is about 300-700 nm. The aluminium alloy film 23B is doped with at least one element to prevent migration (e.g. Cu, Ti, Pd).

The aluminium alloy film 23B in this embodiment is doped with about 1.0% by mass of Si to prevent aluminium spikes and about 0.5% by mass of Cu to prevent migration.

The barrier metal film 23A formed beneath the aluminium alloy film 23B has an effect described as follows. If the aluminium alloy film 23B and the P-type semiconductor substrate 21 are in direct contact with each other, monocrystalline silicone precipitates, which increases the contact resistance value in the areas where it is formed. The presence of the barrier metal film 23A prevents such an increase of the contact resistance value due to precipitation of monocrystalline silicon in the first connection hole 24. It also prevents the formation of aluminium spikes in the area of the first connection hole 24 due to mutual diffusion of the aluminium alloy film 23B and silicon atoms of P-type semiconductor substrate 21. The barrier metal film 23A comprises a titanium film deposited by a sputtering method and a titanium nitride film deposited by a reactive sputtering method. The thickness of the titanium film is preferably about 10 to 40 nm, and the thickness of the titanium nitride film about 40to150 nm.

The titanium film and the titanium nitride film of the barrier metal film 23A are formed by an inline method of sputtering respectively. Due to such inline sputtering, the contact resistance value between the titanium film and the titanium nitride film is substantially reduced, since the titanium nitride film is deposited on the titanium film before the formation of a native oxide layer on the titanium film.

The total thickness of the titanium film and the titanium nitride film is therefore in the range 50 to 190 nm. As the total thickness value of the barrier metal film is about 10% of that of the first interlayer dielectric film layer 22, the step coverage of the aluminium alloy film 23B on the first connection hole 24 is notably improved.

The barrier metal film 23A produces the same effects if it comprises refractory metal, refractory silicide, refractory metal alloy or a laminate structure of these.

Further effects may be achieved if the barrier metal film 23A comprises three layers: a titanium film deposited by a sputtering method, a titanium nitride film deposited by a reactive sputtering method, and a further titanium film deposited by a sputtering method. In this case, the thickness of the lower titanium film is preferably in the range 10 to 40nm, the thickness of the intermediate titanium nitride film is preferably in the range 40 to 150nm, and the thickness of the upper titanium film is preferably in the range 20 to 60 nm. The upper titanium film prevents the invasion of nitrogen, leaving the intermediate titanium nitride film, into the aluminium alloy film 23B. This prevention of the invasion of nitrogen into the aluminium alloy film 23B reduces shortening of the life of the aluminium alloy film 23B due to electromigration.

It is necessary to form the upper titanium film 20 to 60 nm thick to prevent nitrogen invasion into the aluminium alloy film 23B and electromigration of the aluminium film 23B.

Furthermore, the upper titanium film and aluminium alloy film 23B are alloyed. This is effective to suppress the movement of aluminium atoms in the aluminium alloy film 23B. Furthermore, by alloying, titanium gets into the aluminium alloy film 23B. Hence, grain growth in the aluminium alloy film 23B may by suppressed. That is, the occurrence of voids in the aluminium alloy film 23B is prevented. Further, the resistance to stress migration may be enhanced.

It is also necessary to form the upper titanium film 20 to 60 nm thick to increase adequately the resistance to stressmigration.

Similar effects are obtained when the barrier metal film 23A is formed of an alloy film of titanium and tungsten deposited by sputtering method. The thickness of the alloy film of titanium and tungsten in this case is preferably in the range 40 to 150 nm. When the barrier metal film 23A is formed of the alloy film of titanium and tungsten, the titanium and aluminium alloy film 23B are alloyed. As a result, titanium gets into the aluminium alloy film 23B and, consequently, movement of aluminium atoms in the aluminium alloy film 23B is suppressed. It is also possible to suppress grain growth in the aluminium alloy film 23B. That is, the occurrence of voids in the aluminium alloy film 23B may be prevented. Thus, the resistance to stress migration may be enhanced.

The anti-reflection film 23C is formed on the aluminium alloy film 23B. The anti-reflection film 23C reduces the surface reflectively of the first conductive film layer 23. Usually, a step in processing the first conductive film layer 23 into the desired shape by RIE is to form a pattern of photoresist in specified regions. This photoresist pattern is often formed by a reduced projection exposure method. By the light from the reduced projection exposure apparatus, the photoresist pattern is projected onto the photoresist which is accordingly sensitized. At this stage, if there is a material of high surface reflectively present, such as the aluminium alloy film 23B, and in particular if it has a step difference beneath the aluminium alloy film 23B, the photoresist is sensitized not only by the light from the reduced projection exposure apparatus, but also by the light reflected by the aluminium alloy film 23B in the matrix after penetrating through the photoresist. Accordingly, the desired pattern on the photomask is not projected precisely onto the photoresist. Therefore, to overcome this problem, the anti-reflection film 23C is formed on the entire surface of the aluminium alloy film 23B. By reducing the surface reflectivity, unwanted sensitization of the photoresist by the light reflected from the matrix is decreased, and the desired pattern formed on the photomask is precisely transferred to the photoresist. Because of the anti-reflection film 23C, the required pattern of photoresist is also achieved with high precision when forming the second connection hole 25 by anisotropic etching such as RIE.

The anti-reflection film 23C is formed of titanium nitride film deposited by a reactive sputtering method. The thickness of titanium nitride film is preferably in the range 20 to 60 nm. Similar effects can be obtained by forming the anti-reflection film 23C of a refractory metal film, a refractory metal silicide film or an alloy film of refractory metal.

As described above, the barrier metal film 23A, the aluminium alloy film 23B and the anti-reflection film 23C are all formed using the same sputtering method. Since each of these films is chemically reactive, oxide films on the surface of these films are formed by contact with air. The contact resistance is increased by such oxide films. Therefore it is important that these films (the barrier metal film 23A, the aluminium alloy film 23B and the anti-reflection film 23C) are formed using the inline sputtering method.

A second interlayer dielectric film layer 26 is formed on the first conductive film layer 23 formed in a desired shape. The second interlayer dielectric film layer 26 comprises a lower layer of silicon oxide film 26A, an intermediate layer of silicon oxide film 26B using inorganic silica or organic silica and an upper layer of silicon oxide film 26C. The lower layer of silicon oxide film 26A is formed by applying a high frequency in a vapour phase containing, for example, SiH₄ or TEOS (tetraethylorthosilicate). It is deposited by the so-called plasma enhanced chemical vapour deposition method.

The intermediate layer of silicon oxide film 26B is an inorganic silica or organic silica in gel form. The silica is applied onto the silicon oxide film 26A by spinning and baked. The silicon oxide film 26C is formed, in the same way as the silicon oxide film 26A, by plasma enhanced chemical vapour deposition method. In this way, the second interlayer dielectric film layer 26 is formed, comprising three layers of silicon oxide 26A, 26B, 26C.

The lower silicon oxide film 26A is in contact with the first conductive film layer 23 and the silica of the silicon oxide film 26B. The lower silicon oxide film 26A prevents oxidation of the first conductive film layer 23 by the moisture contained in the silica when forming the silicon oxide film 26B. The intermediate silicon oxide film 26B flattens the step in the surface of the first conductive film layer 23, and hence the surface of the upper silicon oxide film 26C is flattened. This helps to prevent breakdown of the second conductive film layer 27, formed on the silicon oxide film 26C in a later process, which may be caused by a step in its surface. The upper silicon oxide film 26C adds to the film strength of the second interlayer dielectric film layer 26 itself. The top silicon oxide film 26C also protects the surface of the intermediate silicon oxide film 26B. The top silicon oxide film 26C further prevents the silicon oxide film 26B absorbing moisture.

The thickness of the silicon oxide film 26A is preferably in the range 100 to 400nm.

To prevent moisture contained in the intermediate silicon oxide film 26B penetrating to the surface of the first conductive film layer 23, it is important that the thickness of the lower silicon oxide firm 26A is preferably in the range 100 to 400 nm. As mentioned above this is formed by plasma enhanced chemical vapour deposition method using gas at least containing TEOS.

The thickness of the silicon oxide film 26B is preferably in the range 150-250 nm. The thickness of the silicon oxide film 26C is preferably in the range 200 to 500 nm. It is necessary that the thickness of the upper silicon oxide film 26C is approximately 200 to 500 nm to provide sufficient mechanical strength to protect the lower silicon oxide film 26B. The total film thickness of the second interlayer dielectric film layer 26 is therefore in the range 500 to 1000 nm.

As a result of this total film thickness of the second interlayer dielectric film layer 26, the insulation between the first conductive film layer 23 and the second conductive film layer 27 is perfect.

A second connection hole 25 is formed at a specified position in the second interlayer dielectric film layer 26. The second connection hole 25 is designed to prevent disconnection of the second conductive film layer 27 formed over the hole in a subsequent process. That is, the hole is tapered so that the opening at the top of the second interlayer dielectric film layer 26 is larger than the opening at the bottom.

A second conductive film layer 27 is formed over an area which at least covers the second connection hole 25. The second conductive film layer 27 comprises two layers: a lower refractory metal film 27A and a top aluminium alloy film 27B. The second conductive film layer 27 is formed with a thickness greater than that of the first conductive film layer 23 in order to lessen the surface step difference of the multilayer wiring.

The refractory metal film 27A and the aluminium alloy film 27B of the second conductive film layer 27 are chemically reactive, and oxide films form on the surface of these films due to contact with air. The contact resistance is increased by such oxide films. Therefore it is important to form these films using the inline sputtering method.

The refractory metal film 27A and the aluminium alloy film 27B which form the second conductive film layer 27 are alloyed. Therefore, movement of aluminium atoms of the aluminium alloy film 27B is suppressed. By alloying, the refractory metal gents into the aluminium alloy film 27B. The refractory metal suppresses grain growth within the aluminium alloy film 27B. As a result, the occurrence of voids in the aluminium alloy film 27B may be prevented, and the resistance of the aluminium alloy film 27B to stress migration is increased. Furthermore, the refractory metal film 27A is also alloyed with the first conductive film layer 23. Consequently the contact between the first conductive film layer 23 and the second conductive film layer 27 is more secure and reduction in yield due to contact failure is avoided.

As discussed above, in order that voids may not occur in the aluminium alloy film 27B, the refractory metal film 27A of the bottom layer and aluminium alloy film 27B are alloyed, and by such alloying, the refractory metal atoms get into the aluminium alloy film. This is also effective to suppress movement of aluminium atoms induced by the stress of the passivation film.

The thickness of the aluminium alloy film 27B is in the range 700-1200 nm. The aluminium alloy film 27B, in the same way as the aluminium alloy film 23B, is doped with at least one element to prevent migration (e.g. Cu, Ti, Pd). The aluminium alloy film 27B used in this embodiment is doped with about 1.0% by mass of Si to prevent the formation of aluminium spikes, and about 0.5% by mass of Cu to prevent migration.

The refractory metal film 27A is formed beneath the aluminium alloy film 27B. The refractory metal film 27A is formed in order to prevent the occurrence of voids in the aluminium alloy film 27B. The refractory metal film 27A is composed of a titanium film deposited by sputtering method. The thickness of the titanium film is in the range 30 to 150 nm.

The second conductive film 27 is composed of two layers, the titanium film and the aluminium alloy film 27B, which are alloyed. This helps to suppress movement of aluminium atoms within the aluminium alloy film 27B. This is also effective to suppress grain growth within the aluminium alloy film 27B as the titanium gets into the crystal grain boundary of the aluminium alloy film 27B. That is, formation of voids inside the aluminium alloy film 27B is suppressed. In addition, the resistance of the aluminium alloy film 27B to stress migration is increased.

The refractory metal film 27A may alternatively be composed of another refractory metal (W, Mo, Ta, Hf, etc), a refractory metal compound, a refractory metal silicide or an alloy of refractory metals. With such alternatives, formation of voids inside the aluminium alloy film 27B is also suppressed. The refractory metal film 27A is appropriately alloyed with the upper aluminium alloy film 27B in the subsequent heat treatment. By way of such alloying, grain growth of aluminium alloy film is suppressed. Thus, by using the material suppressing the grain growth more efficiently, the growth of voids formed in the aluminium alloy film is suppressed. It is also effective to increase the resistance to stress migration.

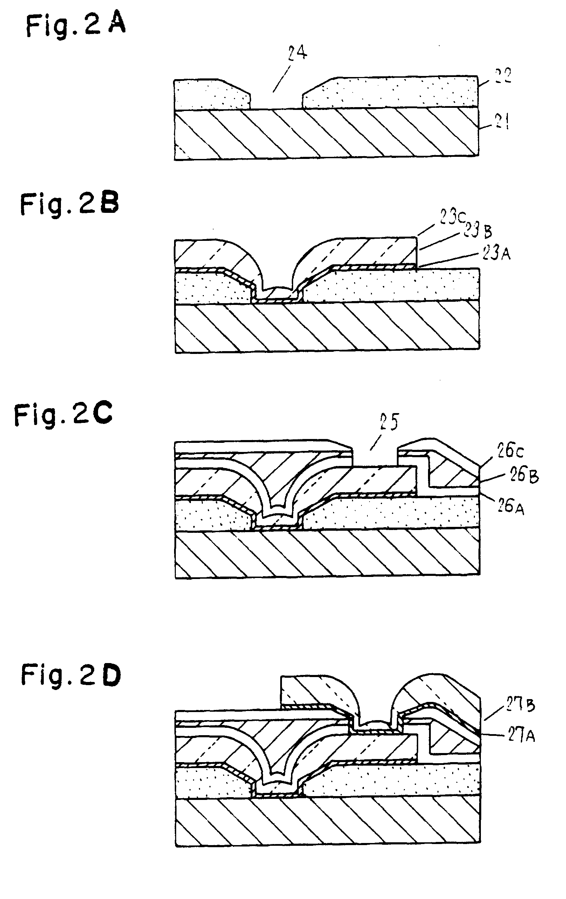

Fig. 2 is process section view useful for explaining a first embodiment of the method of fabricating a semiconductor device of the invention.

As an example, a semiconductor substrate 21 of a first conductive type (P-type) is used in the following description. The method is the same, however, if an N-type semiconductor substrate is used. It is supposed in the following explanation that any one of the ordinary semiconductor elements, such as a MOS transistor, MOS capacitor, bipolar transistor or resistor (not shown) has already been formed on the P-type semiconductor substrate 21.

A first interlayer dielectric film 22 is formed on the P-type semiconductor substrate 21. A suitable layer is a silicon oxide film formed by a low pressure chemical vapour deposition method or an atmospheric pressure chemical vapour deposition method. Such a silicon oxide film may be, for example, a BPSG film formed by an atmospheric pressure chemical vapour deposition method. As an alternative to BPSG film, the silicon oxide film may comprise an SiO₂ film, a PSG film or other dielectric film. The first interlayer dielectric film layer 22 is arranged to maintain dielectric strength between the semiconductor element formed on the P-type semiconductor substrate 21 and the first conductive film layer 23. The thickness of the first interlayer dielectric film layer 22 is preferably in the range 400 to 1000 nm. The first interlayer dielectric film 22 is also arranged to improve the step coverage of the first conductive film layer 23 formed thereon. That is, by means of heat treatment and flowing of the first interlayer dielectric film layer 22, the surface of the first conductive film layer 23 is flattened. For such flowing, the temperature attained by the heat treatment is preferably in the range 850 to 950°C. The flowing is conducted in a nitrogen gas atmosphere or a mixed gas atmosphere of hydrogen and oxygen. When the flowing is conducted a mixed gas atmosphere of hydrogen and oxygen the surface is flattened more smoothly than in a nitrogen gas atmosphere.

Next, by selectively removing a specified portion of the first interlayer dielectric film layer 22, a first connection hole 24 is formed. The first connection hole 24 is formed so as not to break the upper first conductive film layer 23. To etch the upper part of the first interlayer dielectric film layer 22, isotropic etching such as wet etching is preferably used. After etching of the upper part, to etch the remaining lower part first interlayer dielectric film layer 22 anisotropic etching such as reactive ion etching (RIE) is preferably used. In this way, the first connection hole 24 is formed. The shape of the first connection hole 24 is tapered so that the opening at the top of the first interlayer dielectric film layer 22 is larger than the opening at the bottom. Alternatively it may be possible to form the required shape of the first connection hole 24 by anisotropic etching only (Fig. 2A).

After etching, a native oxide film forms on the exposed P-type semiconductor substrate 21.

The native oxide film on the P-type semiconductor substrate 21 exposed at the bottom of the first connection hole 24 is removed, for example, by use of a diluting solution such as hydrochloric acid. The first conductive film layer 23 is then formed. The first conductive film layer 23 comprises three layers: a barrier metal film 23A, an aluminium alloy film 23B and an anti-reflection film 23C. The first conductive film layer 23 may alternatively comprise a single layer of aluminium alloy film alone, or two layers of barrier metal film and an aluminium alloy film, or two layers of aluminium alloy film and an anti-reflection film. The first conductive film layer 23 is processed into a desired pattern by anistropic etching such as RIE.

The next stage is a heat treatment in, for example, a hydrogen gas atmosphere, or a mixed gas atmosphere of hydrogen and nitrogen, at a temperature of approximately 450°C. This heat treatment causes the first conductive film layer 23 and silicon atoms of the P-type semiconductor substrate 21 to be properly alloyed. As a result, the contact characteristic is stabilized. Also, this heat treatment causes any damage caused by the anisotropic etching, such as RIE, to be recovered (Fig. 2B).

The aluminium alloy film 23B is formed by a sputtering method. At his stage the film thickness is in the range 300 to 700 nm. The aluminium alloy film 23B is doped with at least one element to prevent migration e.g. (Cu, Ti, Pd, etc).

The aluminium alloy film 23B is this embodiment is doped with about 1.0% by mass of Si to prevent aluminium spikes, and about 0.5% by mass of Cu to prevent migration.

The barrier metal film 23A is formed beneath the aluminium alloy film 23B.

The presence of the barrier metal film 23A prevents an increase of the contact resistance value due to precipitation of monocrystalline silicon in the first connection hole 24. It also prevents the formation of aluminium spikes in the first connection hole 24 due to mutual diffusion of the aluminium alloy film 23B and silicon atoms of P-type semiconductor substrate 21. The barrier metal film 23A comprises two layers of titanium film deposited by a sputtering method and a titanium nitride film deposited by a reactive sputtering method. The thickness of the titanium film is in the range 10 to 40 nm, and the thickness of the titanium nitride film is in the range 40 to 150 nm.

The barrier metal film 23A provides the same effects if it alternatively comprises refractory metal, refractory metal silicide, refractory metal compound, or a laminate structure of these.

The barrier metal film 23A has further effects if it comprises three layers: a titanium film deposited by a sputtering method, a titanium nitride film deposited by a reactive sputtering method and a further titanium film deposited by a sputtering method. In this case the thickness of the lower layer of the titanium film is preferably in the range 10 to 40 nm, the thickness of the intermediate layer of the titanium nitride film is preferably in the range 40 to 150 nm and the thickness of the upper titanium film is preferably in the range 20 to 60 nm. The upper titanium film prevents the nitrogen leaving the intermediate titanium nitride film entering the aluminium alloy film 23B. This prevention of the entry of nitrogen into the aluminium alloy film 23B reduces shortening of the life of the aluminium alloy film 23B due to electromigration.

Furthermore, the upper titanium film and the aluminium alloy film 23B are alloyed. As a result movement of aluminium atoms in the aluminium alloy film 23B is suppressed. By alloying, moreover, occurrence of voids in the aluminium alloy film 23B may be prevented. In addition, the resistance to stress migration may be enhanced.

Similar effects are produced if the barrier metal film 23A comprises an alloy film of titanium and tungsten deposited by sputtering method. The thickness of the alloy film of titanium and tungsten in this case is preferably in the range 40 to 150 nm. When the barrier metal film 23A is formed of the alloy film of titanium and tungsten, the titanium and the aluminium alloy film 23B are alloyed. As a result, the titanium atoms get into the aluminium alloy film 23B and consequently resistance to stress migration is enhanced.

The anti-reflection film 23C is formed on the aluminium alloy film 23B. The anti-reflection film 23C decreases the surface reflectively of the first conductive film 23.

The anti-reflection film 23C is formed of a titanium nitride film deposited by a reactive sputtering method. The thickness of the titanium nitride film is preferably in the range 20-60 nm. The anti-refection film 23C produces similar effects if it comprises a refractory metal film, a refractory metal silicide film, or an alloy film of refractory metal.

Next a second interlayer dielectric film layer 26 is formed on the first conductive film layer 23 in a specified pattern. The second interlayer dielectric film layer 26 comprises a lower layer of silicon oxide film 26A, an intermediate layer of silicon oxide film 26B using inorganic silica or organic silica and an upper layer of silicon oxide film 26C. The lower silicon oxide film 26A is formed by applying a high frequency in a vapour phase containing, for example, SiH₄ or TESO (tetraethylorthosilicate). It is deposited by the so called plasma enhanced chemical vapour deposition method.

The intermediate silicon oxide film 26B is organic silica or inorganic silica in gel form. The silica is applied onto the silicon oxide film 26A by spinning, and baked. The silicon oxide film 26C is formed by the plasma enhanced chemical vapour deposition method in the same way as the silicon oxide film 26A.

The lower silicon oxide film 26A is in contact with the first conductive layer 23 and the silica of the silicon oxide film 26B. The lower silicon oxide film 26A prevents oxidation of the first conductive film layer 23 by the moisture contained in silica when forming the silicon oxide film 26B. The intermediate silicon oxide film 26B flattens the step in the surface of the first conductive film layer 23 of the matrix, and hence the surface of the upper silicon oxide film 23C is flattened. As a result, in the subsequent process, the second conductive film layer 27 formed on the silicon oxide film 26C is prevented from being broken due to a step in the surface. The upper silicon oxide film 26C adds to the strength of the second intermediate insulation film layer 26 itself. It further protects the surface of the intermediate silicon oxide film 26B. It moreover prevents moisture absorption by the silicon oxide film 26B.

The thickness of the silicon oxide film 26A is preferably in the range 100 to 400 nm. The silicon oxide film 26B is formed by repeating the spinning application process of silica and baking process at a temperature of about 450°C several times. The thickness of the silicon oxide film 26B is preferably in the range 150 to 250 nm. The thickness of the silicon oxide film 26C is preferably in the range 200 to 500 nm. The total thickness of the second interlayer dielectric film layer 26 is therefore in the range 500 to 1000nm.

Any one of the three silicon oxide films 26A, 26B, 26C forming the second interlayer dielectric film layer 26 may be a silicon oxide film formed by one of the following methods. For example, in a vapour phase containing at least TEOS, after thickly depositing the silicon oxide film by plasma enhanced chemical vapour deposition method by applying high frequency, the entire surface may be etched to form a silicon oxide film having a specified thickness. Alternatively the silicon oxide film may be formed by pyrolysis of a mixed gas of ozone and TEOS.

A specified portion of the second interlayer dielectric film layer 26 is removed selectively to form a second connectin hole 25. The second connection hole 25 is formed so as not to cause breakdown of the second conductive film layer 27 formed on the upper part in a subsequent process. The upper region of the second interlayer dielectric film layer 26 may be formed by isotropic etching such as wet etching, and the lower region may be formed by anistopic etching such as RIE (reactive ion etching). As a result, the hole is formed in a taper so that the opening at the top of the second interlayer dielectric film layer 26 is larger than the opening at the bottom. Alternatively it may be possible to form the required shape of the second connection hole 25 by anistopic etching only.

After forming the second connection hole 25, heat treatment is applied at a temperature of about 380°C. This causes any damage caused by etching to be repaired and the silicon oxide film 26B exposed on the side wall of the second connection hole 25 to be baked solid simultaneously (Fig. 2C).

After the formation of the second connection hole 25, a native oxide film, particularly aluminium oxide (Al₂O₃) forms on the exposed surface of the first conductive film 23 layer. This is removed by sputtering using Argon ion. For this purpose the pressure of argon gas is about 5 mtorr (667mPa).

Removal of the native oxide film is intended to improve the contact between the first conductive film layer 23 exposed in the second connection hole 25 and the second conductive film layer 27, thereby avoiding contact failure.

The process of removing the native oxide film on the first conductive film layer 23 is not limited to the sputtering method using argon, but any other suitable method may be employed. For example, RIE using reactive gas may be used.

The second conductive film layer 27 is then formed without exposing the cleaned surface of the first conductive film layer to the air.

The second conductive film layer 27 comprises two layers: a lower layer of refractory metal film 27A and an upper layer of aluminium alloy film 27B. The second conductive film layer 27 is formed with a greater thickness than that of the first conductive film layer 23 in order to lessen the surface step difference of the multilayer wiring.

Subsequently the second conductive film layer 27 may be formed in a specified shape by anisotropic etching such as RIE.

Following this, heat treatment is conducted at a temperature of about 450°C, for example, in a hydrogen gas atmosphere, or in a mixed gas atmosphere of hydrogen and nitrogen. This heat treatment causes the refractory metal film 27A and aluminium alloy film 27B of the second conductive film layer 27 to be alloyed. This is effective to suppress the movement of aluminium atoms within the aluminium alloy film 27B. By alloying, moreover, the refractory metal atoms get into the aluminium alloy film 27B and this suppresses grain growth in the aluminium alloy film 27B. As a result, formation of voids in the aluminium alloy film 27B is suppressed and the resistance of the aluminium alloy film 27B to stress migration is increased. Furthermore, by the heat treatment, the refractory metal film 27A also alloys with the first conductive film layer 23 exposed at the bottom of the second connection hole 25. Accordingly, a reduction in the yield due to contact failure may be prevented. Also, any damage caused by anisotropic etching such as RIE may be repaired by way of the heat treatment (Fig. 2D).

In order to prevent formation of voids in the aluminium alloy film 27B, the refractory metal film 27A of the bottom layer and the aluminium are alloyed. By alloying, as mentioned above, the refractory metal atoms get into the aluminium alloy film. This suppresses movement of aluminium atoms induced by the stress of the passivation film. To expedite such suppression it is necessary to ensure that alloying of the bottom refractory metal 27A and top aluminium alloy film 27B is uniform. Also this prevents formation of an interface layer that may impede alloying, between the aluminium alloy film 27B and the refractory metal film 27A. Such an interface layer in previously known processes is, for example, an oxide layer of the refractory metal film. Therefore, deposition of the refractory metal film 27A and deposition of the aluminium alloy film 27B are performed as a continuous process without exposure to the atmosphere. By forming these layers as a continuous process, the occurrence of voids within the aluminium alloy film 27B is suppressed.

The aluminium alloy film 27B may be formed by a sputtering method. Its film thickness is preferably in the range 700 to 1200 nm. The aluminium alloy film 27B is doped with at least one element to prevent migration (e.g. Cu, Ti, Pd), in the same way as the aluminium alloy film 23B. The aluminium alloy film 27B used in this embodiment is doped with approximately 1.0% by mass of Si to prevent aluminium spikes, and approximately 0.5% by mass of Cu to prevent migration.

The refractory metal film 27A is formed beneath the aluminium alloy film 27B. The aluminium alloy film 27A is formed in order to prevent formation of voids in the aluminium alloy film 27B. The refractory metal film 27A is composed of a titanium film deposited by sputtering method. The thickness of the titanium film is preferably in the range 30 to 100 nm.

When the second conductive film layer 27 is composed of two layers of titanium film and aluminium alloy film 27B, the titanium film and aluminium alloy film 27B are alloyed. Thus, movement of aluminium atoms within the aluminium alloy film 27B is suppressed. Also, the titanium atoms get into the crystal grain boundaries of the aluminium alloy film 27B, thereby suppressing the grain growth of the aluminium alloy film 27B, and formation of voids inside the aluminium alloy film 27B, and formation of voids inside the aluminium alloy film 27B may be prevented. In addition, the resistance of the aluminium alloy film 27B to stress migration may be increased.

The refractory metal film 27A may alternatively be composed of another refractory metal (W, Mo, Ta, Hg, etc.), a refractory metal compound, a refractory metal silicide or an alloy of refractory metals. Similarly in this case occurrence of voids within the aluminium allow film 27B may be prevented. Moreover, the refractory metal film 27A and the aluminium alloy film 27B of the top layer are appropriately alloyed by subsequent heat treatment. By alloying, grain growth within the aluminium alloy film is suppressed. Thus, by using a material suppressing the grain growth, the occurrence of voids formed in the aluminium alloy film may be suppressed more effectively. It is thus more effective for increasing resistance to stress migration.

Following the above steps it is advantageous to form a passivation film (not shown) comprising a PSG film and a silicon nitride film. The PSG film relaxes the high stress of the silicon nitride film. Stress in the silicon nitride film may induce breakdown of the second conductive film layer 27. The PSG film is formed, for example, by an atmospheric pressure chemical vapour deposition method. The thickness of PSG film is preferably in the range 100 to 400 nm. The silicon nitride film prevents moisture and pollutants penetrating the device. The silicon nitride film is formed, for example, by plasma enhanced chemical vapour deposition method. The thickness of silicon nitride film is preferably in the range 500 to 1200 nm.

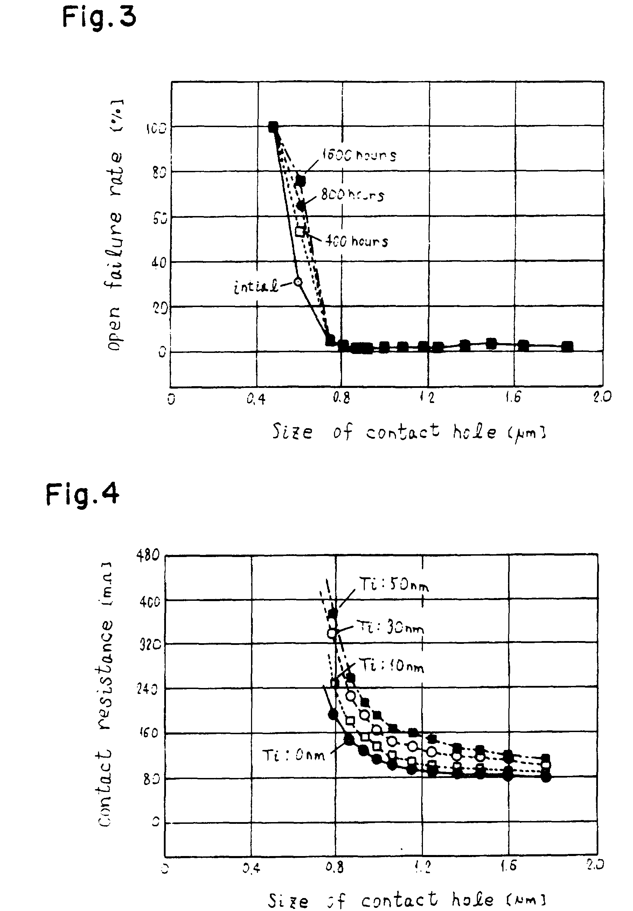

Fig. 3 shows the results of reliability tests of the second connection hole of a semiconductor device fabricated according to this invention.

The particular semiconductor device tested is fabricated as follows. On a 6-inch P-type semiconductor substrate a BPSG film 600nm thick is deposited. On the BPSG film, a barrier metal film and an aluminium alloy film are deposited as a first conductive film layer. The barrier metal is formed of two layers: a titanium film and a titanium nitride film. The thickness of the titanium film is 20nm, and the thickness of the titanium nitride film is 100nm. The aluminium alloy film is doped with 1.0% by mass of silicon and 0.5% by mass of copper. The thickness of the aluminium alloy film is 600nm. A second interlayer dielectric film is formed of a silicon oxide film 400nm thick, a silicon oxide film of inorganic silica or organic silica in gel form, and a silicon oxide film 300 nm thick. A second conductive film layer is formed of a titanium film 50nm thick and an aluminium alloy film 1000 nm thick. A passivation film is formed of a PSG film 300nm thick and a silicon nitride film 800 nm thick.

On a P-type semiconductor substrate formed as described above 100,000 second connection holes are disposed in series. A total of 120 contact chains between the first conductive film layer and second conductive film layer are formed.

The sample as described above is different from the prior art in that the second conductive film layer is composed of two layers of titanium film and aluminium alloy film.

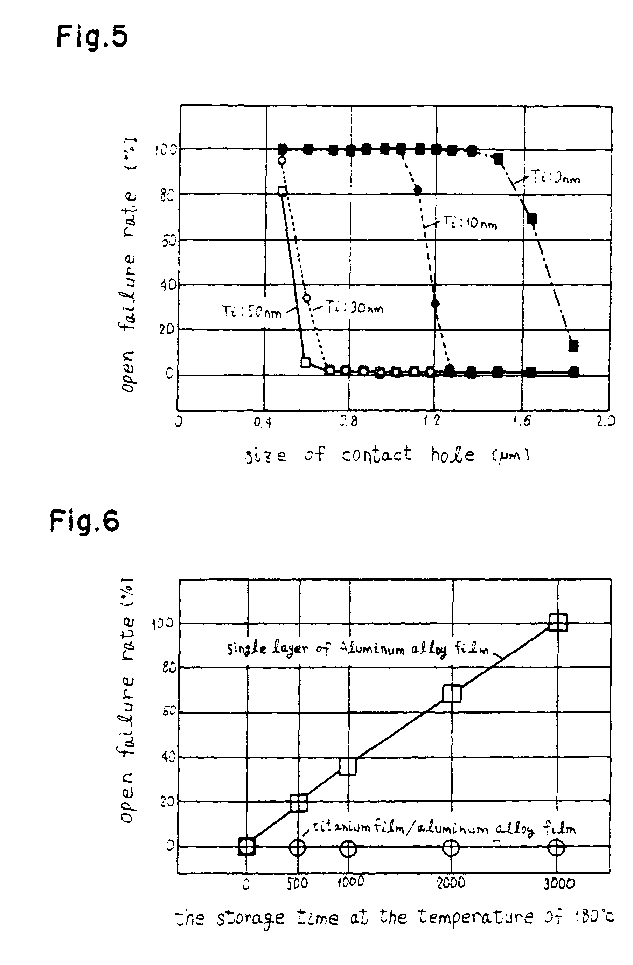

Fig. 3 shows the results of open failure rate tests of the contact chains of this semiconductor device conducted by investigating the electrical conducting state. The horizontal axis denotes the contact hole size or the diameter of the second connection holes. The vertical axis represents the open failure rate. The open failure rate immediately after manufacture is indicated by the curve marked "initial" in the diagram. The other curves represent the failure rates obtained after storage at a high temperature (180°C) in a nitrogen atmosphere for various lengths of time. The high temperature storage times are 400 hours, 800 hours and 1600 hours, and the open failure rate of the devices after storage for each length of time is shown. As can be seen from Fig. 5 when the diameter of the second connection holes is greater than about 0.6um, storage at a high temperature (180°C) does not increase the open failure rate, unlike in the prior art shown in Figs. 8 and 9. Thus the formation of the titanium film in the bottom layer of the second conductive film causes the open failure rate to be lower than in the prior art. At the same time although the formation of the titanium film in the bottom layer of the aluminium alloy film does not improve the coverage of aluminium alloy film in the second connection hole, even where the thickness of the second conductive film layer is very thin, the open failure rate is lower than in the prior art. This fact suggests that voids are not formed in the aluminium alloy film of the top layer of the second conductive film layer in the second connection hole and occurrence of voids is suppressed by this invention. Even with contact hole sizes which are prone to open failure due to growth of voids in the prior art, open failure does not occur in this invention. In the prior art, when the contact hole size is smaller than 1.4 m, problems arise with the reliability of semiconductor devices. In this invention, by contrast, the contact hole size may be as small as 0.6 um without causing adverse effects to the reliability of the semiconductor device. In this invention therefore reduction in the reliability of semiconductor devices by formation of voids may be prevented.

Fig. 4 shows the relationship between the contact hole size and contact resistance for samples formed in the same way as described above in relation to Fig. 3. However, the titanium film which was used as the refractory metal film in the bottom layer the second conductive film layer, was formed with various thickness (10 nm, 30 nm, and 50 nm) in different devices and the resistance of the contact chain was measured in the various cases.

The contact resistance is given in terms of the resistance of each second connection hole, and is found by dividing the total resistance value of the contact chain by 10,000 which is the number of contacts in each contact chain.

The contact resistance is compared between the prior art and the above described embodiment. In this embodiment, when the thickness of the titanium film in the second conductive film layer is 50 nm, as compared to a prior art device without a titanium film and having an aluminium alloy film 1000nm thick as the second conductive film layer, the contact resistance is approximately 30-40% higher.

The resistance approaches the resistance of the conventional constitution if the titanium film is made thinner than 50nm. If the titanium film is made thicker than 50 nm, the contact resistance increases further. However, in order to suppress the formation of voids in the second connection holes effectively, it is more advantageous to increase the thickness of the titanium film.

Fig. 5 shows the relationship between the contact hole size and the open failure rate with a titanium film 10 nm, 30 nm, and 50 nm thick. The contact hole size indicates the diameter of the second connection holes. In this study, all the samples were subject to storage at a high temperature of 180°C for 1000 hours in a nitrogen atmosphere. The diagram also shows the result of a prior art device without a titanium film.

When the thickness of the titanium film is 30 nm, the diameter of the second connection holes at which the open failure rate begins to increase is greater than that when the thickness of titanium film is 50 nm. That is, when the thickness of titanium film is 30 nm, the open failure rate begins to increase when the diameter of second connection holes is about 0.7 um, while in the case of titanium film 50 nm thick, it is about 0.6 um. A more marked difference can be seen with a titanium film 10 nm thick.

Therefore, in the design of semiconductor devices in which it is desired to maintain the reliability of second connection holes while making them very small, and to attempt to minimise any increase in wiring resistance, it is necessary to select a titanium film having an appropriate thickness depending on the semiconductor device and the properties required. For example, when manufacturing a semiconductor device in which the diameter of second connection holes is 1.0 um, with an aluminium alloy film 700 to 1200 nm thick, a titanium film 50 nm thick should be used in the second conductive film layer.

Fig. 6 shows the relationship between the open failure rate and the length of time for which the semiconductor device is left in a nitrogen atmosphere at 180°C. The result suggests that the open failure rate for disconnection varies due to the occurrence of voids within the second conductive film layer. The change of open failure rate in this case means the transitional change of the open failure rate when leaving the semiconductor device at the temperature of 180°C.

The diagram illustrates the case using a single layer of aluminium alloy film in the prior art and using an aluminium alloy film with a titanium film beneath as the embodiment of this invention.

In the sample according to the invention, the second conductive film layer is composed of a titanium film 50 nm thick and an aluminium alloy film 1000 nm thick. The second conductive film layer has a wire width of 0.8 um and a wiring length of 60 cm. 267 such patterns were fabricated on a 6-inch P-type semiconductor substrate, and the electric conductive state was investigated and the open failure rate was calculated. Also, because of the ease of forming voids in the aluminium alloy film of the second conductive film layer in the semiconductor device, a silicon nitride film with a high stress is usually formed as a passivation film directly on the second conductive film layer. Such a silicon nitride film is formed 800 nm thick by a plasma enhanced chemical vapour deposition method.

As shown in Fig. 6, with a single layer of aluminium alloy film as in the prior art, as the storage time at the temperature of 180°C increases the open failure rate of the semiconductor device also increases. This indicates that voids formed in the aluminium alloy film grow as the storage time passes. Because of such void growth, wire breakdown is likely to occur, and the open failure rate increases. By contrast, by depositing a titanium film, which is a refractory metal as the bottom layer of the second conductive film layer as in the invention, it is known that voids are prevented from forming in the aluminium alloy film in the second conductive film layer. Even after 3000 hours, the second conductive film layer is not broken, and the open failure rate does not increase. Thus, by depositing the titanium film as a lower layer, the reliability of second connection holes is improved, and the resistance of the second conductive film layer (the aluminium alloy film) to stress migration is enhanced.

Furthermore, since titanium is a very reactive metal, alloying is promoted onto the first conductive film layer at the bottom of the second connection holes. As a result, contact failures are markedly decreased for the connection between the first conductive film layer and the second conductive film layer through the second connection holes. Thus, the refractory metal film is capable of preventing the formation of voids in the aluminium alloy film, and by using titanium film as the refractory metal film contact failures in the second connection holes may be reduced.

Titanium is a highly reactive material, and similar effects can also be obtained by using an alloy film of titanium and another refractory metal, for example, an alloy film of titanium and tungsten.

Because the titanium film is chemically reactive the titanium and the first conductive film layer 27 at the bottom of the second connection hole 25 are encouraged to alloy. This is effective in that contact failure between the first conductive film layer 23 and the second conductive film layer 27 is markedly decreased.

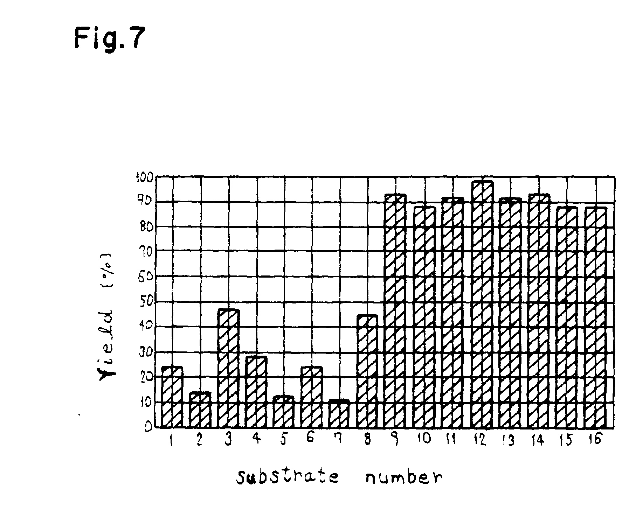

Fig. 7 is a diagram showing the yield of semiconductor devices fabricated according to this invention as compared with the prior art. Semiconductor devices with 900,000 second connection holes in a chip with an area of 30 mm² are fabricated on a 6-inch semiconductor substrate and Fig. 7 is a diagram illustrating yield of various devices. Semiconductor devices fabricated according to the prior art are designated as substrate numbers 1 to 8, and semiconductor devices fabricated according to this invention are designated as substrate numbers 9 to 16.

The yield is higher for semiconductor devices of this invention than for those of the prior art. This shows that the reliability of semiconductor devices fabricated according to this invention is superior to that of the prior art. That is, the titanium film or other refractory metal film as the lower part of the second conductive film layer prevents the occurrence of voids in the aluminium alloy film and decreases the frequency of contact failure in the second connection holes.

Thus, by composing the second conductive film layer of two layers of refractory metal and aluminium alloy film, the formation of voids in the aluminium alloy film is suppressed. As a result, the reliability of second connection holes smaller than in the prior art may be maintained, and the wiring density of the semiconductor device may be greatly increased. That is, in an area smaller than in the prior art, a semiconductor device with equivalent functions may be fabricated, or alternatively, without increasing the chip size, a semiconductor device having higher functions may be fabricated. By using a titanium film or an alloy film of titanium and tungsten as the refractory metal, moreover, it is possible to connect with the first conductive film more securely than in the prior art. Hence, semiconductor devices may be manufactured more successfully than in the prior art.

## Claims

1. A semiconductor device comprising:
a semiconductor substrate (21);
a first interlayer dielectric film layer (22) formed on the semiconductor substrate (21) and having at least one first connection hole (24) at a specified position therein;
a first conductive film layer (23) formed on the first interlayer dielectric film layer and over a specified area including said at least one first connection hole (24);
a second interlayer dielectric film layer (26) formed on the first conductive film layer (23) and having at least one second connection hole (25) at a specified position therein; and
a second conductive film layer (27) comprising a refractory metal film (27A) and an aluminium alloy film (27B) formed on the second interlayer dielectric film layer (26) over a specified area including said at least one second connection hole (25);
characterized in that the thickness of the refractory metal film (27A) is in the range 30-100nm, and in that the refractory metal film (27A) is alloyed with the aluminium alloy film (27B) and the first conductive film layer (23) in the at least one second connection hole (25).

2. A semiconductor device according to claim 1, wherein the first conductive film layer (23) comprises a refractory metal film (23A) alloyed with the semiconductor substrate, a nitride film of the refractory metal formed on the refractory metal film, an aluminium alloy film (23B) formed on the nitride film, and an anti-reflection film (23C) formed on the aluminium alloy film.

3. A semiconductor device according to claim 1, wherein the first conductive film layer comprises a first refractory metal film alloyed with the semiconductor substrate, a nitride of the first refractory metal formed on the first refractory metal film, a second refractory metal film formed on the nitride film, an aluminium alloy film formed on the second refractory metal film, and an anti-reflection film formed on the aluminium alloy film.

4. A method of fabricating a semiconductor device comprising:
forming a first interlayer dielectric film layer (22) on a semiconductor substrate (21),
forming at least one first connection hole (24) in the first interlayer dielectric film layer to expose the semiconductor substrate,
removing oxide film from the exposed surface of the semiconductor substrate,
forming a first conductive film layer (23) on the first interlayer dielectric film layer and over a region including at least the exposed semiconductor substrate surface.
forming a second interlayer dielectric film layer (26) on the first conductive film layer,
forming at least one second connection hole (25) in the second interlayer dielectric film layer (26) to expose the first conductive film layer;
removing oxide film from the first conductive film layer;
forming a second conductive film layer (27) on said second interlayer dielectric film layer comprising a lower layer of a refractory metal film (27A) and an upper layer of an aluminium alloy film (27B) over a region including at least the at least one second connection hole (25);
characterized in that the refractory metal film (27A) is formed to have a thickness in the range 30-100nm, in that the layer of a refractory metal film (27A) and the layer of aluminium alloy film (27B) are formed sequentially in a continuous process without exposure to air, and by further comprising heating in a reducing atmosphere after the formation of the second conductive film layer (27) whereby the refractory metal film layer (27A) is alloyed with the aluminium alloy film (27B) and the first conductive film layer (23) in the at least one second connection hole (25).

5. A method of fabricating a semiconductor device according to claim 4, wherein said step of heating is performed at a temperature of approximately 450°C.

## Patentansprüche

1. Halbleitervorrichtung, die aufweist:
ein Halbleitersubstrat (21);
eine erste, dielektrische Zwischenschicht-Filmschicht (22), die auf dem Halbleitersubstrat (21) gebildet ist und mindestens ein erstes Verbindungsloch (24) an einer spezifizierten Position darin besitzt;
eine erste, leiffähige Filmschicht (23), die auf der ersten, dielektrischen Zwischenschicht-Filmschicht und über einem spezifizierten Bereich, der das mindestens eine, erste Verbindungsloch (24) umfaßt, gebildet ist;
eine zweite, dielektrische Zwischenschicht-Filmschicht (26), die auf der ersten, leitfähigen Filmschicht (23) gebildet ist und mindestens ein zweites Verbindungsloch (25) an einer spezifizierten Position darin besitzt; und
eine zweite, leiffähige Filmschicht (27), die einen Film (27A) aus hochschmelzendem Metall und einen Aluminium-Legierungs-Film (27B), gebildet auf der zweiten, dielektrischen Zwischenschicht-Filmschicht (26) über einem spezifizierten Bereich, der das mindestens eine, zweite Verbindungsloch (25) umfaßt, aufweist;
dadurch gekennzeichnet, daß die Dicke des Films (27A) aus hochschmelzendem Metall in dem Bereich von 30-100 nm liegt und daß der Film (27A) aus hochschmelzendem Metall mit dem Aluminium-Legierungs-Film (278) und der ersten, leiffähigen Filmschicht (23) in dem mindestens einen, zweiten Verbindungsloch (25) legiert ist.

2. Halbleitervorrichtung nach Anspruch 1, wobei die erste, leiffähige Filmschicht (23) einen Film (23A) aus hochschmelzendem Metall, legiert mit dem Halbleitersubstrat, einen Nitrid-Film aus dem hochschmelzenden Metall, gebildet auf dem Film aus hochschmelzendem Metall, einen Aluminium-Legierungs-Film (23B), gebildet auf dem Nitrid-Film, und einen Antireflexions-Film (23C), gebildet auf dem Aluminium-Legierungs-Film, aufweist.

3. Halbleitervorrichtung nach Anspruch 1, wobei die erste, leiffähige Filmschicht einen ersten Film aus hochschmelzendem Metall, legiert mit dem Halbleitersubstrat, ein Nitrid des ersten hochschmelzenden Metalls, gebildet auf dem ersten Film aus hochschmelzendem Metall, einen zweiten Film aus hochschmelzendem Metall, gebildet auf dem Nitrid-Film, einen Aluminium-Legierungs-Film, gebildet auf dem zweiten Film aus hochschmelzendem Metall, und einen Antireflexions-Film, gebildet auf dem Aluminium-Legierungs-Film, aufweist.

4. Verfahren zum Herstellen einer Halbleitervorrichtung, das aufweist:
Bilden einer ersten, dielektrischen Zwischenschicht-Filmschicht (22) auf einem Halbleitersubstrat (21),
Bilden mindestens eines ersten Verbindungslochs (24) in der ersten, dielektrischen Zwischenschicht-Filmschicht, um das Halbleitersubstrat freizulegen,
Enffernen eines Oxidfilms von der freigelegten Fläche des Halbleitersubstrats,
Bilden einer ersten, leiffähigen Filmschicht (23) auf der ersten, dielektrischen Zwischenschicht-Filmschicht und über einem Bereich, der mindestens die freigelegte Halbleitersubstratoberfläche umfaßt,
Bilden einer zweiten, dielektrischen Zwischenschicht-Filmschicht (26) auf der ersten, leiffähigen Filmschicht,
Bilden mindestens eines zweiten Verbindungslochs (25) in der zweiten, dielektrischen Zwischenschicht-Filmschicht (26), um die erste, leitfähige Filmschicht freizulegen;
Enffernen eines Oxidfilms von der ersten, leiffähigen Filmschicht;
Bilden einer zweiten, leiffähigen Filmschicht (27) auf der zweiten, dielektrischen Zwischenschicht-Filmschicht, die eine untere Schicht aus einem Film aus hochschmelzendem Metall (27A) und eine obere Schicht aus einem Aluminium-Legierungs-Film (27B) über einem Bereich, der mindestens das mindestens eine, zweite Verbindungsloch (25) umfaßt, aufweist;
gekennzeichnet dadurch, daß der Film (27A) aus hochschmelzendem Metall so gebildet ist, um eine Dicke in dem Bereich von 30-100 nm zu haben, daß die Schicht aus einem Film (27A) aus hochschmelzendem Metall und die Schicht aus einem Aluminium-Legierungs-Film (27B) sequentiell in einem kontinuierlichen Prozeß ohne Aussetzen gegenüber Luft gebildet werden und daß es weiterhin ein Aufheizen in einer reduzierenden Atmosphäre nach dem Bilden der zweiten, leiffähigen Filmschicht (27) aufweist, wodurch die Filmschicht (27A) aus hochschmelzendem Metall mit dem Aluminium-Legierungs-Film (27B) und der ersten, leiffähigen Filmschicht (23) in dem mindestens einen, zweiten Verbindungsloch (25) legiert wird.

5. Verfahren zum Herstellen einer Halbleitervorrichtung nach Anspruch 4, wobei der Schritt eines Aufheizens bei einer Temperatur von ungefähr 450°C durchgeführt wird.

## Revendications

1. Dispositif semi-conducteur comprenant :
un substrat à semi-conducteur (21) ;
une première couche de film diélectrique inter-couche (22) formée sur le substrat semi-conducteur (21) et ayant au moins un premier trou de connexion (24) en une position spécifiée dans celle-ci ;
une première couche de film conducteur (23) formée sur la première couche de film diélectrique inter-couche et au-dessus d'une zone spécifiée incluant ledit au moins un premier trou de connexion (24) ;
une seconde couche de film diélectrique inter-couche (26) formée sur la première couche de film conducteur (23) et ayant au moins un second trou de connexion (25) en une position spécifiée dans celle-ci ; et
une seconde couche de film conducteur (27) comprenant un film de métal réfractaire (27A) et un film d'alliage d'aluminium (27B) formée sur la seconde couche de film diélectrique inter-couche (26) au dessus d'une zone spécifique incluant ledit au moins un second trou de connexion (25) ;
caractérisé en ce que l'épaisseur du film de métal réfractaire (27A) est dans la gamme de 30-100 nm, et en ce que le film de métal réfractaire (27A) est allié avec le film d'alliage d'aluminium (27B) et la première couche de film conducteur (23) dans ledit au moins un second trou de connexion (25).

2. Dispositif semi-conducteur selon la revendication 1, dans lequel la première couche de film conducteur (23) comprend un film de métal réfractaire (23A) allié avec le substrat semi-conducteur, un film de nitrure du métal réfractaire formé sur le film de métal réfractaire, un film d'alliage d'aluminium (23B) formé sur le film de nitrure, et un film anti-réfléchissant (23C) formé sur le film d'alliage d'aluminium.

3. Dispositif semi-conducteur selon la revendication 1, dans lequel la première couche de film conducteur comprend un premier film de métal réfractaire allié avec le substrat semi-conducteur, un nitrure du premier métal réfractaire formé sur le premier film de métal réfractaire, un second film de métal réfractaire formé sur le film de nitrure, un film d'alliage d'aluminium formé sur le second film de métal réfractaire, et un film anti-réfléchissant formé sur le film d'alliage d'aluminium.

4. Procédé de fabrication d'un dispositif semi-conducteur, comprenant :
la formation d'une première couche de film diélectrique inter-couche (22) sur un substrat semi-conducteur (21) ;
la formation d'au moins un premier trou de connexion (24) dans la première couche de film diélectrique inter-couche pour exposer le substrat semi-conducteur,
l'enlèvement du film d'oxyde de la surface exposée du substrat semi-conducteur ;
la formation d'une première couche de film conducteur (23) sur la première couche de film diélectrique inter-couche et au-dessus d'une région incluant au moins la surface exposée du substrat semi-conducteur,
la formation d'une seconde couche de film diélectrique inter-couche (26) sur la première couche de film conducteur,
la formation d'au moins un second trou de connexion (25) dans la seconde couche de film diélectrique inter-couche (26) pour exposer la première couche de film conducteur ;
l'enlèvement du film d'oxyde de la première couche de film conducteur ;
la formation d'une seconde couche de film conducteur (27) sur ladite seconde couche de film diélectrique inter-couche comprenant une couche inférieure d'un film de métal réfractaire (27A) et une couche supérieure d'un film d'alliage d'aluminium (27B) au-dessus une région incluant ledit au moins un second trou de connexion (25) ;
caractérisé en ce que le film de métal réfractaire (27A) est formé de façon à avoir une épaisseur dans la gamme de 30-100 nm, en ce que la couche d'un film de métal réfractaire (27A) et la couche de film d'alliage d'aluminium (27B) sont formées séquentiellement par un processus continu sans exposition à l'air, et par le fait qu'il comprend en outre un chauffage dans une atmosphère réductrice après la formation de la seconde couche de film conducteur (27), d'où il résulte que la couche de film de métal réfractaire (27A) est alliée avec le film d'alliage d'aluminium (27B) et la première couche de film conducteur (23) dans ledit au moins un second trou de connexion (22).

5. Procédé de fabrication d'un dispositif semi-conducteur selon la revendication 4, dans lequel ladite étape de chauffage est effectuée à une température d'environ 450°C.
